# FASCICULE DE BREVET EUROPEEN

(11) **EP 2 469 707 B1**
(45) Date de publication et mention de la délivrance du brevet: **10.07.2013**
(21) Numéro de dépôt: 11192845.3
(22) Date de dépôt: 09.12.2011
(51) Int. Cl.: H03G 3/30, G01S 19/13

(54) **Dispositif de contrôle automatique de gain pour récepteur de positionnement par satellites**
Automatische Kontrollvorrichtung der Verstärkung für satellitengesteuerten Positionsempfänger
Automatic gain control device for satellite positioning receivers

(30) Priorité: 23.12.2010 FR 1005085
(43) Date de publication de la demande: 27.06.2012
(73) Titulaire: Thales, 92200 Neuilly Sur Seine (FR)
(72) Inventeur: Kirby, Estelle, 26000 Valence (FR); Revol, Marc, 26120 Upic (FR)
(74) Mandataire: Lucas, Laurent Jacques

(56) Documents cités:
- WO-A1-2010/013391
- FR-A1- 2 916 589
- US-A- 5 101 416

## Description

La présente invention concerne un dispositif de contrôle automatique de gain pour récepteur de positionnement par satellites. Elle s'applique notamment aux systèmes de radionavigation par satellite, communément désignés suivant le sigle GNSS désignant la terminologie anglaise "Global Navigation Satellite System", et peut être mise en oeuvre dans tout récepteur de navigation.

Un système de positionnement par satellite ou GNSS, comprend une pluralité d'émetteurs de signaux disposés sur autant de satellites formant une constellation. Des exemples de systèmes de navigation par satellite de type GNSS peuvent être cités, notamment : le système communément désigné par le sigle "GPS" correspondant à la terminologie anglaise "Global Positioning System", et le système communément désigné "Galileo". Un minimum de quatre satellites de positionnement permettent à un récepteur mobile apte à traiter les signaux reçus en provenance de ceux-ci, de délivrer des données de position du récepteur, en termes de coordonnées géographiques (x,y,z) à un instant t déterminé. Les données transmises par les satellites de positionnement occupent une bande passante plus large que ce que requiert le débit de données à transmettre, dans le but de réduire l'influence des signaux interférents, et de réduire les niveaux de puissance des signaux transmis de manière à ce que ceux-ci soient masqués dans le bruit de fond. Ainsi, selon des techniques en elles-mêmes connues, le spectre des signaux transmis est étalé, une onde porteuse étant modulée par un signal de données superposé à un signal d'étalement de bruit pseudo-aléatoire à haute fréquence. Une corrélation des signaux reçus avec des codes locaux permet d'extraire le signal utile du bruit. La fonction de corrélation d'un récepteur GNSS requiert un rapport signal sur bruit suffisant afin de permettre la démodulation des données, et poursuivre le signal en code et en phase.

Un certain nombre de bandes de fréquences sont allouées aux systèmes de navigation de type GNSS. Récemment, de nouvelles bandes de fréquences ont été allouées aux systèmes du type GPS dit "modernisé", et au système Galileo, respectivement : les bandes de fréquences L5 et E5a, E5b. Ces dernières bandes de fréquences présentent la particularité d'être déjà allouées à des systèmes de radionavigation pulsés, parmi lesquels il est notamment possible de citer le système communément désigné par le sigle DME correspondant à la terminologie anglaise "Distance Measuring Equipment". En outre, ces bandes de fréquences sont également en limite d'une bande de fréquence allouée à des systèmes radars, parmi lesquels des radars tels que des radars météorologiques ou des radars primaires fonctionnent typiquement dans une bande de fréquence adjacente à la bande E5b.

Ainsi, du point de vue d'un récepteur de navigation par satellites de type GNSS et notamment de type GPS modernisé ou Galileo, les signaux issus des systèmes de radionavigation tels que le DME, ou bien des radars, sont considérés respectivement comme des interférences dans la bande de fréquences d'intérêt, ou comme des interférences hors-bande. Les systèmes de radionavigation et de radars précités sont habituellement fixés au sol, et un aéronef peut être soumis à différents types d'interférences pulsées selon les zones survolées. En outre, ces interférences pulsées sont très puissantes à l'émission ; ainsi, lors des survols par exemple des continents européen et américain, dans lesquels la concentration en sources d'interférences est importante, le taux d'occupation des impulsions peut être élevé, voire supérieur à 100%, lorsqu'il existe des recouvrements des interférences pulsées.

Dans le cadre de la protection aux perturbations liées à la présence de signaux indésirables, les interférences précitées posent des difficultés dans le traitement temporel par les récepteur GNSS. Notamment, un récepteur GNSS comprend un système de Commande Adaptative de Gain, communément désigné par l'acronyme CAG, agissant sur le signal radiofréquence reçu via une antenne, et après pré-amplification, et permettant d'optimiser en aval le codage du signal radiofréquence d'entrée dans la dynamique d'un Convertisseur Analogique Numérique, communément désigné par l'acronyme CAN. Certains scénarios d'interférences pulsées déstabilisent la CAG, et rendent délicat voire impossible tout traitement numérique en aval du CAN.

Les récepteurs GNSS doivent par conséquent être robustes à des interférences pulsées dans la bande utile GNSS avec forts taux de répétition, ce qui correspond à des scénarii d'interférences pulsées par exemple de type DME, et également être robustes à des interférences pulsées puissantes hors-bande utile, notamment produites par des radars.

Une solution connue visant à affranchir les récepteurs GNSS des interférences causées par des impulsions, est la technique désignée suivant le terme anglais "blanking", qui consiste à repérer le signal interférant et à supprimer des traitements ultérieurs le signal reçu perturbé par celui-ci. Cette solution est inopérante lorsque la densité d'interférences augmente au point de recouvrir de manière quasi-permanente le signal utile. Dans ce cas, le blanking conduit à éliminer tout signal utile en même temps que le signal interférant. Ce type de scénario est susceptible de se produire dans une grande partie de l'espace aérien européen, notamment à une altitude de l'ordre de 40.000 pieds où le nombre de balises DME vues par un aéronef peut être de l'ordre de 60 aux moments de densité maximale de trafic. Il est possible pour améliorer l'efficacité du blanking de découper la bande en plusieurs sous-bandes et de réaliser le blanking sur chacune des sous-bandes, ce qui, pour des interférences données, laisse subsister une part plus importante du signal utile et améliore donc le rapport signal à bruit.

Dans les deux cas il est nécessaire de disposer d'une référence de bruit qui permette de s'affranchir du biais d'estimation du bruit thermique qui apparaît dans les scenarios d'interférences denses. Une solution consiste à calibrer une référence de bruit ; cependant cette solution n'est stable ni dans le temps, ni en température, ni par rapport à la dynamique à laquelle est soumis le récepteur.

Ainsi selon une technique améliorée et décrite dans la demande de brevet publiée sous la référence FR 2,916,589, il a été proposé de fournir une estimation du bruit thermique sans recourir à la calibration. Selon cette technique, la CAG est asservie à la fonction de densité de probabilité de la puissance ou de l'amplitude du signal radiofréquence, et se base sur le principe que la partie gauche de la courbe de densité de probabilité en fonction de la puissance ou de l'amplitude, n'est pas ou peu affectée par des impulsions d'interférence dans la bande utile. Cette technique s'avère très efficace pour des impulsions dans la bande utile, même à fort taux de répétition. Cependant, cette technique s'avère moins efficace face à des scénarii de fort taux d'occupation d'impulsions hors-bande, saturant le préamplificateur qui travaille dans toute la bande L. Quand celui-ci est saturé par une impulsion dans la bande L mais hors-bande utile, son gain s'écroule dans toute la plage L. L'estimateur de CAG est ainsi biaisé et le signal utile n'est donc plus amplifié, il devient difficile voire impossible de le faire ressortir du bruit par corrélation.

Un but de la présente invention est de pallier au moins les inconvénients précités, en proposant un dispositif de contrôle automatique de gain pour récepteur GNSS s'adaptant au mieux au bruit thermique, dans les différents scénarii d'interférences possibles, notamment en présence d'impulsions dans la bande et hors-bande présentant des taux d'occupation variables et possiblement très forts.

A cet effet, l'invention a pour objet un dispositif de contrôle automatique de gain pour récepteur de positionnement par satellites comprenant au moins un module radiofréquence restituant un signal radiofréquence filtré représentatif des signaux reçus par une antenne et amplifié par un amplificateur à gain variable compris dans le module radiofréquence, un convertisseur analogique-numérique restituant des échantillons numérisés du signal radiofréquence, et un module de traitement du signal traitant le signal numérisé, le dispositif de contrôle automatique de gain étant mis en oeuvre dans le module de traitement du signal et réalisant une boucle d'asservissement en restituant un signal de commande du gain de l'amplificateur à gain variable, et étant caractérisé en ce qu'il comprend des moyens d'estimation du taux d'occupation temporelle des impulsions dans la bande utile, des moyens d'estimation d'une grandeur caractéristique choisie dans le groupe comprenant l'amplitude et la puissance des signaux échantillonnés, le taux d'occupation temporelle des impulsions dans la bande utile déterminant les pondérations appliquées respectivement aux écarts négatifs et positifs résultant d'une comparaison entre la grandeur caractéristique des échantillons numérisés et une valeur de consigne CCAG, par un module de fonction non-linéaire, les signaux issus du module de fonction non-linéaire étant intégrés sur une période déterminée pour former ledit signal de commande du gain.

Dans un mode de réalisation de l'invention, la détermination des pondérations peut être mise en oeuvre dans un module de décision recevant en entrée une valeur de taux d'occupation d'impulsions dans la bande utile, et restituant en sortie une information de pondération audit module de fonction non-linéaire.

Dans un mode de réalisation de l'invention, le module de fonction non-linéaire peut appliquer lesdites pondérations à partir d'une table de vérité de correspondance entre des taux d'occupation temporelle des impulsions dans la bande utile, et des réglages des taux respectifs de pondérations appliqués auxdits écarts négatifs et positifs.

Dans un mode de réalisation de l'invention, lesdits réglages de pondération peuvent appliquer un taux de pondération de X% aux écarts négatifs et un taux de pondération de (1-X)% aux écarts négatifs, X étant compris entre 0 et 100, et étant d'autant plus élevé que le taux d'occupation temporelle des impulsions dans la bande utile est élevé.

Dans un mode de réalisation de l'invention, le dispositif de contrôle automatique de gain peut comprendre des moyens d'ajustement de la valeur de consigne CCAG configurés pour ajuster la valeur de la consigne CCAG en fonction du taux d'occupation temporelle des impulsions dans la bande utile.

Dans un mode de réalisation de l'invention, la détermination du taux d'occupation temporelle des impulsions dans la bande utile peut être mise en oeuvre dans un module de détection d'impulsions dans la bande utile compris dans ledit module de traitement du signal.

Dans un mode de réalisation de l'invention, la détermination du taux d'occupation temporelle des impulsions dans la bande utile peut être mise en oeuvre dans un module d'analyse des impulsions dans la bande utile comprenant au moins un filtre adapté spectralement à des types d'interférences pulsées prédéterminés.

Dans un mode de réalisation de l'invention, ladite boucle d'asservissement peut comprendre un module de gain de boucle CAG dont le gain ajustable détermine le temps de réponse de la boucle d'asservissement.

Dans un mode de réalisation de l'invention, le gain du module de gain de boucle peut être ajusté par un signal de commande restitué par le module de décision en fonction du taux d'occupation temporelle des impulsions dans la bande utile.

D'autres caractéristiques et avantages de l'invention apparaîtront à la lecture de la description, donnée à titre d'exemple, faite en regard des dessins annexés qui représentent :
- la figure 1, un schéma illustrant de manière synoptique une chaîne de réception d'un récepteur de positionnement par satellites ;
- la figure 2, une courbe illustrant la densité de probabilité en fonction de la puissance ou de l'amplitude, pour un signal correspondant au bruit thermique seul ;
- la figure 3, la superposition de deux courbes illustrant la densité de probabilité en fonction de la puissance ou de l'amplitude, respectivement pour un signal de bruit thermique seul et un signal incluant le bruit thermique et des signaux issus d'impulsions dans la bande utile ;
- la figure 4, une courbe illustrant la densité de probabilité en fonction de la puissance ou de l'amplitude, pour un signal incluant le bruit thermique et des impulsions de type DME ;
- la figure 5, la superposition de deux courbes illustrant la densité de probabilité en fonction de la puissance ou de l'amplitude, pour un signal de bruit thermique, respectivement en présence et en absence d'impulsions hors-bande à fort taux d'occupation ;
- la figure 6, un diagramme fonctionnel illustrant un exemple d'architecture d'un récepteur GNSS comprenant une CAG selon un premier exemple de réalisation de l'invention ;
- la figure 7, un diagramme fonctionnel illustrant un exemple d'architecture d'un récepteur GNSS comprenant une CAG selon un second exemple de réalisation de l'invention.

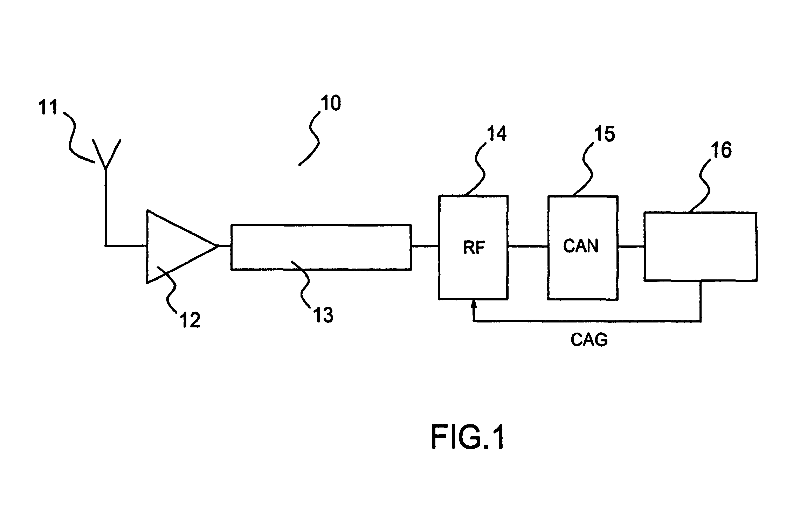

La figure 1 présente un schéma illustrant de manière synoptique une chaîne de réception 10 d'un récepteur GNSS 10. Une chaîne de réception 10 peut comprendre une antenne 11 recevant notamment les signaux en provenance des satellites dans la bande L. L'antenne 11 est reliée à un préamplificateur 12, par exemple un préamplificateur à faible bruit amplifiant fortement le signal dans la bande L. Un câble 13 relie la sortie du préamplificateur 12 à un module radiofréquence ou module RF 14. Le module RF 14 filtre le signal et le descend en fréquence ; il contient également un amplificateur à gain variable, par exemple commandé en tension, tel qu'un amplificateur du type communément désigné par le sigle VGA correspondant à la terminologie anglaise "Voltage Gain Amplifier". Le signal filtré, ramené dans la bande et amplifié par le module RF 14 est alors numérisé par un convertisseur analogique-numérique ou CAN 15. Un module de traitement du signal 16 effectue alors un traitement du signal numérique, et commande notamment le module RF 14 pour la mise en oeuvre de la CAG. La commande de gain peut se faire selon différents algorithmes mis en oeuvre dans le module de traitement du signal 16.

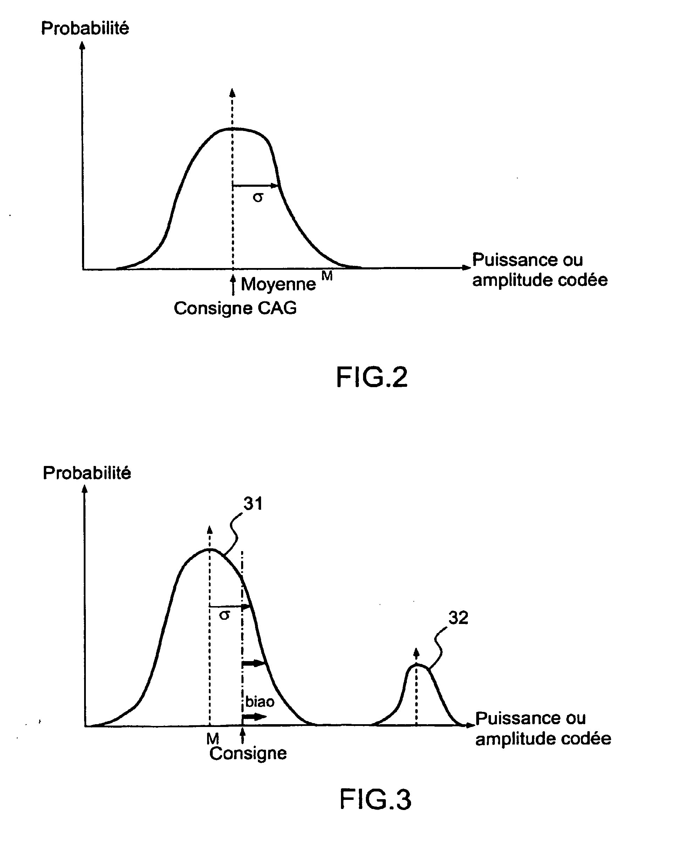

La figure 2 présente une courbe illustrant la densité de probabilité en fonction de la puissance ou de l'amplitude codée, pour un signal correspondant au bruit thermique seul.

Les échantillons numérisés suivent typiquement une loi gaussienne avec une puissance moyenne M et un écart-type σ.

Une CAG "classique" vise à asservir la moitié des échantillons numérisés par le CAN au-dessus d'une valeur de consigne de CAG, et la moitié des échantillons en-dessous de la valeur de consigne de CAG. Ainsi, la CAG vise à asservir la puissance moyenne M sur la valeur de consigne de CAG.

La figure 3 présente une première courbe 31 illustrant la densité de probabilité en fonction de la puissance ou de l'amplitude codée, pour un signal de bruit thermique seul. La première courbe 31 est similaire à la courbe présentée sur la figure 2 décrite ci-dessus. Une seconde courbe 32 illustre la densité de probabilité en fonction de la puissance ou de l'amplitude, pour les échantillons correspondant à un signal incluant du bruit thermique et des signaux issus d'une impulsion dans la bande utile. La seconde courbe 32 présente sensiblement également une allure de gaussienne.

Ainsi que cela est illustré par la figure 3, une CAG "classique" se biaise en présence d'une interférence pulsée dans la bande, ceci étant dû au fait qu'une telle CAG vise à asservir la moitié des échantillons numérisés par le CAN au-dessus d'une valeur de consigne de CAG, et la moitié des échantillons en-dessous de la valeur de consigne de CAG. Le biais dépend du taux d'occupation des impulsions, et est d'autant plus élevé que le taux d'occupation des impulsions est élevé. Certaines CAG peuvent avantageusement accorder plus de poids aux échantillons de fortes puissances, le biais peut alors également dépendre de la puissance reçue provenant des impulsions.

Le recours à une technique de blanking telle que présentée précédemment, avant l'estimation de la puissance de la CAG, permet le "masquage" de l'impulsion, et partant un débiaisage de la CAG, comme dans un scénario de bruit thermique seul tel qu'illustré par la figure 2.

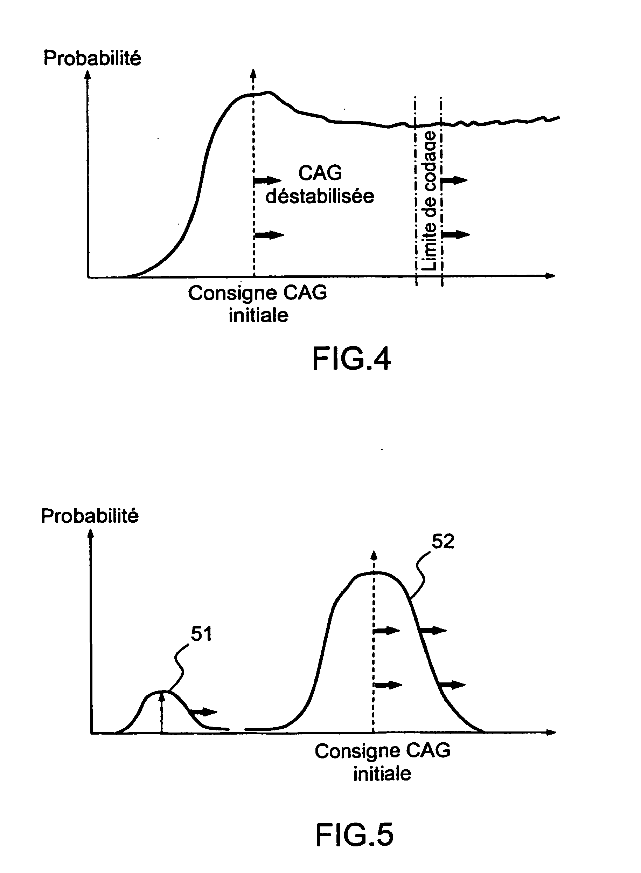

La figure 4 présente une courbe illustrant la densité de probabilité en fonction de la puissance ou de l'amplitude, pour un signal incluant le bruit thermique et des impulsions de type DME.

Une CAG soumise à un scénario typique de la présence d'impulsions de type DME présente une probabilité de puissance codée telle qu'illustrée par la courbe.

La consigne de CAG initiale implique que le rapport 50% des échantillons au-dessus et 50% au-dessous n'est plus respecté. Le gain de la CAG diminue donc et la limite de codage - c'est-à-dire le nombre de bits sur lequel le bruit doit être codé - augmente, et ainsi de suite : la CAG continue alors à adapter la consigne, jusqu'à ce que le signal initial ne soit plus codé. Dans une telle situation, le récepteur GNSS se trouve alors rapidement en échec d'acquisition, ou en perte de poursuite du signal.

Selon la technique précitée, et faisant l'objet de la demande de brevet FR 2,916,589, l'asservissement de la CAG ne se fait que sur la partie gauche de la courbe : par exemple la partie gauche de la première courbe 31 présentée par la figure 3, ou la partie gauche de la courbe présentée par la figure 4. De la sorte, la CAG est débiaisée dans les scénarii y correspondant.

Cependant, ainsi que cela est décrit précédemment, cette technique s'avère moins efficace face à des scénarii de fort taux d'occupation d'impulsions hors-bande, saturant le préamplificateur qui travaille dans toute la bande L. Quand celui-ci est saturé par une impulsion dans la bande L mais hors-bande utile, son gain s'écroule dans toute la plage L. Dans un tel scénario, la densité de probabilité de puissance ou d'amplitude codée est illustrée par la figure 5.

La figure 5 présente une première courbe 51 illustrant la densité de probabilité en fonction de la puissance ou de l'amplitude codée, pour les échantillons correspondant à un signal incluant du bruit thermique et des signaux issus d'une impulsion hors-bande. Une seconde courbe 52 illustre la densité de probabilité en fonction de la puissance ou de l'amplitude, pour des échantillons correspondant à un signal de bruit thermique seul.

Ainsi que cela est illustré par la première courbe 51 de la figure 5, il existe une probabilité suivant une loi sensiblement gaussienne, pour que l'amplitude ou la puissance du signal échantillonné soit faible, lors de la présence d'impulsions hors-bande. Ceci est dû au fait qu'en présence d'impulsions hors-bande typiquement issues d'émissions radars, le gain s'écroule en raison de la saturation du préamplificateur.

La présente invention se fonde sur une CAG basée sur une exploitation de la partie "non perturbée" de la fonction de densité de probabilité, c'est-à-dire, dans l'exemple d'un scénario impliquant des interférences causées par des impulsions hors-bande : de la seconde courbe 51 correspondant aux échantillons de forte puissance, de manière à ne pas saturer les échantillons utiles en cas de fort taux d'occupation hors-bande.

D'une manière plus globale, la présente invention propose d'adapter le comportement de la CAG, cette dernière étant basée sur la fonction de densité de probabilité de l'amplitude ou de la puissance des signaux échantillonnés, en fonction des scénarii d'interférence détectés.

Le principe de la présente invention consiste notamment à adapter le récepteur GNSS à des scénarii de type forte densité d'interférence hors-bande ou à des scénarii de type forte intensité d'interférence dans la bande, afin d'améliorer l'estimation du bruit thermique et des interférences continues en présence d'interférences pulsées quels que soient leur puissance ou leur amplitude, leur taux de répétition et leur fréquence porteuse.

La présente invention se fonde notamment sur les principes suivants :
- les échantillons filtrés de faible amplitude sont peu sensibles aux interférences pulsées si les interférences pulsées hors-bande n'entraînent pas de compression de la chaîne de traitement analogique
- les échantillons filtrés d'amplitude forte sont peu sensibles aux interférences pulsées si les interférences pulsées dans la bande sont peu nombreuses ou de faibles amplitudes.

Il est ainsi possible d'identifier deux situations critiques pour la stabilité de l'asservissement de la CAG en présence d'interférences pulsées :
- le cas d'une densité importante d'interférences pulsées "non-comprimantes", c'est-à-dire de puissance inférieure au point de saturation des différents étages RF, dans la bande utile de réception, dans lequel le contrôle de la CAG sera asservi sur la queue de distribution des amplitudes faibles de la densité de probabilité du bruit, c'est-à-dire les échantillons non affectés par la présence des impulsions fortes ;
- le cas d'impulsions fortes hors-bande, excédant le point de compression de la chaine de réception, dont les non-linéarités contribuent à la déformation de la queue de distribution des amplitudes de la densité spectrale du bruit.

La présente invention propose de baser l'asservissement de la CAG sur la détection de la densité temporelle des interférences pulsées, plutôt que sur la détection de saturation du signal reçu. La présente invention propose notamment de réaliser l'asservissement de la CAG en s'appuyant en priorité sur la distribution des échantillons d'amplitude élevée, correspondant à la queue de distribution de la partie droite de la densité de probabilité, à la condition que la densité d'impulsions en réception soit négligeable. De la sorte, il est possible à la fois de tirer le meilleur profit de la distribution de bruit en absence d'impulsion dans la bande tout en restant robuste au risque de saturations provoquées par des interférences hors-bande.

Par contre, si la densité d'interférences pulsées augmente, la densité de probabilité correspondant aux amplitudes les plus fortes se trouve modifiée par rapport à celle obtenue en bruit seul. Dans ce cas, il est alors proposé de réduire ce risque en réalisant l'asservissement de la CAG sur la base des quantiles de distribution des échantillons de bruit d'amplitudes faibles, correspondant à la partie gauche de la densité de probabilité, dont l'estimation n'est pas affectée par des interférences d'amplitudes fortes.

Dans le cas de l'existence d'une densité d'impulsions importante dans la bande de réception, conjointement à l'existence d'impulsions comprimantes hors-bande, la non prise en compte de la densité d'impulsions dans la bande faisant courir le risque d'une divergence de l'estimation de la CAG, il est proposé en priorité de sécuriser son traitement, au détriment de l'identification des situations de compression. En effet, celles-ci ne se traduisent in fine que par une erreur de la consigne d'asservissement, entraînant tout au plus une réduction de la dynamique utile dans les cas où, en tout état de cause, l'existence simultanée d'impulsions dans la bande aura principalement contribué à réduire cette dynamique.

La détection du taux d'occupation temporelle des impulsions dans la bande utile constitue un indicateur très pratique et d'une mise en oeuvre aisée. Cet indicateur permet de lever une alerte si la robustesse à la compression potentielle de la RF aux scénarii d'interférences hors-bande pulsées puissantes devient critique pour la robustesse à l'occupation d'interférences pulsées dans la bande bien réelle car mesurée. Lorsque l'occurrence d'interférences pulsées dans la bande devient non négligeable, un détecteur de taux d'occupation alerte la CAG et la commande de la fonction non-linéaire se déplace vers la gauche de la courbe de densité de probabilité.

Selon une spécificité de l'invention, le récepteur GNSS comprend des moyens de détection de taux d'occupation temporelle des interférences pulsées dans la bande utile. La période de mise à jour de l'indicateur de taux d'occupation temporelle des interférences pulsées dans la bande utile a typiquement un ordre de grandeur bien inférieur au temps de réaction de la CAG, le rapport minimum étant typiquement supérieur à 10. L'indicateur de taux de d'occupation temporelle des interférences pulsées dans la bande utile fournit une donnée d'entrée permettant d'ajuster de manière optimale la protection contre les impulsions dans la bande.

Ainsi, dans le cas d'un scénario d'interférences pulsées dans la bande de puissance ou d'amplitude inférieure au point de saturation radiofréquence, un taux d'occupation temporelle des interférences pulsées dans la bande utile élevé conduit la CAG à se baser sur la partie gauche de la courbe de densité de probabilité pour réaliser l'asservissement du niveau de bruit de sortie de chaîne, pour extrapolation de la commande de gain pour le VGA.

Par exemple, si le taux d'occupation temporelle des interférences pulsées dans la bande utile est de 80%, il est possible de réguler la commande de la CAG à partir de valeurs plus basses (quantile de distribution de bruit à 10%) afin que 90% des échantillons du CAN codés aient une amplitude au-dessus de cette consigne.

La CAG peut alors réaliser une estimation de la moyenne de la puissance du bruit permettant l'asservissement du gain de la chaine (en bruit) avec une boucle d'ordre 1. Pour cela, les échantillons issus de la RF et échantillonnés par le CAN sont comparés à un seuil de consigne ajusté sur la base d'une distribution de bruit Gaussienne de sorte que 90% (dans le cas de l'exemple à 10%) des échantillons d'amplitude ou de puissance doivent être supérieurs à la consigne. L'erreur obtenue par cette soustraction est traitée de manière non-linéaire afin de minimiser l'erreur résiduelle, l'éventuel dépassement ou "overshoot" et la constante de temps de la CAG. Cette dernière technique est décrite dans la demande de brevet publiée sous la référence FR 2,916,538.

La fonction non-linéaire peut être définie de la manière suivante : les échantillons d'amplitude inférieure au seuil peuvent par exemple être pondérés avec un poids de 0,9, alors que les échantillons d'amplitude supérieure au seuil seront pondérés avec un poids de 0,1. L'asservissement de la boucle de CAG trouve ainsi un point d'équilibre lorsque l'écart entre les deux répartitions d'amplitudes vaut 0 (un tel réglage est désigné "10%/90%"). D'une manière similaire, un réglage selon lequel les écarts négatifs sont pondérés avec un poids X, et les écarts positifs avec un poids 1-X, peut être désigné "X% / (1-X)%".

Egalement, dans l'exemple précité d'un scénario d'interférences pulsées dans la bande peu nombreuses ou de faibles amplitudes, c'est à dire lorsque le taux de d'occupation temporelle des interférences pulsées dans la bande utile est faible, le but de la CAG est de chercher à détecter la partie droite de la courbe de densité de probabilité, puis d'extrapoler la commande pour le VGA. Dans ce cas, il est par exemple possible de pondérer les écarts négatifs avec un poids de 0,1 et les écarts positifs avec un poids 0,9, c'est-à-dire selon un réglage "90% / 10%".

Selon une spécificité de la présente invention, les pondérations appliquées aux écarts peuvent être modifiées en temps réel, en fonction de la densité d'interférences pulsées dans la bande utile. Le critère représentatif du scénario est le taux d'occupation des impulsions dans la bande utile. Cet indicateur peut être réglé d'une manière optimale de manière à assurer par ailleurs la meilleure robustesse possible aux interférences hors-bande "comprimantes", c'est-à-dire de puissance supérieure au point de saturation des différents étages RF.

Les réglages peuvent par exemple être ajustés suivant le tableau (1) présenté ci-après, formant une table de vérité et figurant les réglages pouvant être appliqués à la pondération des écarts, en fonction du taux d'occupation détecté des impulsions dans la bande utile :

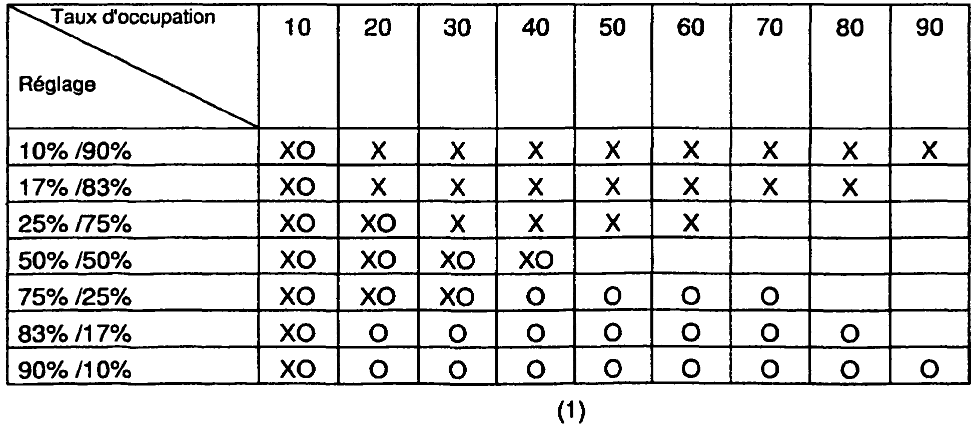

Dans le tableau (1) ci-dessus, les "X" représentent des réglages acceptables pour des impulsions dans la bande utile, et les "0" représentent des réglages acceptables pour des impulsions hors-bande au-dessus du point de saturation du module RF, les colonnes s'appliquant à différents taux d'occupation détectés.

La priorité est donnée au traitement de densité importante d'impulsions dans la bande (le réglage 10%/90% par exemple), le réglage au plus juste des consignes fournissant alors la meilleure robustesse au cas des impulsions comprimantes hors bande, ce qui correspond à un cas opérationnel d'interférences DME, typique en aéronautique, pour les bandes de fréquences : L5/E5a, E5b.

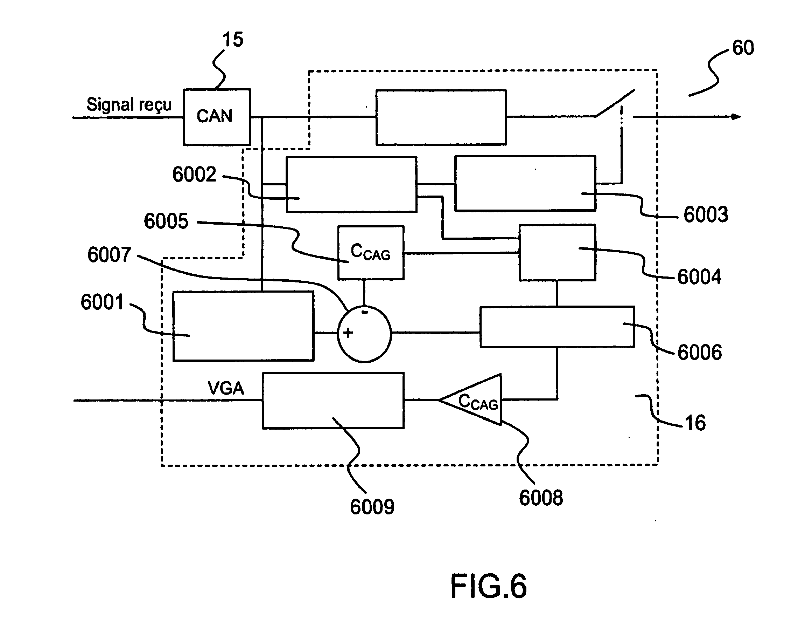

La figure 6 présente un diagramme fonctionnel illustrant un exemple d'architecture d'un récepteur GNSS comprenant une CAG selon un premier exemple de réalisation de l'invention.

Un signal d'entrée, par exemple issu du module RF 14 en référence à la figure 1 décrite précédemment, est appliqué en entrée du CAN 15. Le module de traitement du signal 16 restitue notamment un signal de commande de la CAG à destination du module RF 14, ainsi que cela est décrit précédemment en référence à la figure 1. Le CAN 15 dispose d'un nombre de bits suffisant pour coder correctement le signal utile, ainsi que les impulsions de puissance ou d'amplitude supérieure à celle du bruit thermique. Le CAN 15 peut avantageusement coder des signaux d'interférences continus, si le récepteur GNSS est conçu pour les éliminer numériquement, via par exemple l'intégration d'un filtre à réponse impulsionnelle finie, communément désigné suivant l'acronyme FIR, en sortie du CAN 15.

Le module du traitement du signal 16 comprend un module d'estimation d'amplitude ou de puissance 6001 estimant le signal codé issu du CAN 15. L'estimation de l'amplitude ou de la puissance du signal codé par le CAN 15 peut être réalisée suivant différentes techniques en elles-mêmes connues, selon des choix d'architecture de récepteur notamment en fonction de critères de coût de fabrication et de consommation. Cette estimation peut être effectuée par une électronique dédiée, ou bien dans un circuit logique programmable de type FPGA, suivant l'acronyme désignant la terminologie anglaise "Field Programmable Gate Array", ou encore via un logiciel dédié mis en oeuvre dans un microcontrôleur. Cette estimation est effectuée en utilisant le maximum d'informations sur la forme temporelle des interférences pulsées, afin que le taux d'occupation soit le plus faible possible. Si ces impulsions sont traitées ultérieurement par traitement fréquentiel ou blanking par exemple, une ligne à retard 6010 peut être mise en oeuvre afin de tenir compte de la latence induite par la détection des pulses.

Le signal codé issu du CAN 15 est également appliqué en entrée d'un module de détection d'impulsions dans la bande utile 6002. La détection d'impulsions dans la bande peut être effectuée de manière plus ou moins adaptée à la forme des interférences dans la bande. Il est à noter que les interférences hors-bande ne sont pas visibles du module de détection d'impulsions dans la bande utile 6002 car elles ont été filtrées par les filtres radiofréquence compris dans le module RF, et ont éventuellement saturé les préamplificateurs. Dans ce cas, le signal utile n'est pas codé : les échantillons seront constitués de bruit créé par les derniers étages RF. Le module de détection d'impulsions dans la bande utile 6002 permet notamment la mise en oeuvre d'un calcul d'un indicateur de taux d'occupation des impulsions dans la bande utile.

Le module de détection d'impulsions dans la bande utile 6002 est relié à un module de traitement des impulsions 6003. Le module de traitement des impulsions 6003 peut mettre en oeuvre diverses techniques en elles-mêmes connues de traitement d'impulsions, telles que des méthodes d'écrêtage, de blanking, d'excision spectrale, d'inversion de puissance, etc.

Un module de décision CAG 6004 reçoit en entrée une valeur de taux d'occupation des impulsions dans la bande utile, restituée par le module de détection d'impulsions dans la bande utile 6002. Le module de décision CAG 6004 constitue une spécificité de la présente invention. Il restitue en sortie une consigne de CCAG 6005, et des signaux à destination d'un module de fonction non-linéaire 6006. Le module de fonction non-linéaire 6006 met en oeuvre une fonction non-linéaire, adaptant par exemple le poids accordé aux erreurs négatives ou en saturant les résidus, ainsi que décrit précédemment. L'algorithme de décision peut par exemple se baser sur le tableau (1) présenté ci-dessus. La fonction non-linéaire mise en oeuvre dans le module de fonction non-linéaire 6006 peut par exemple donner plus de poids à des échantillons négatifs qu'à des échantillons positifs, ou elle peut saturer l'erreur de manière dissymétrique etc.

Un bloc comparateur 6007 réalise une comparaison entre la consigne de CCAG 6005 et l'amplitude ou la puissance codée restituée par le module d'estimation d'amplitude ou de puissance 6001.

Le module de fonction non-linéaire 6006 restitue également en sortie un signal de commande CAG à destination d'un module de gain de boucle CAG 6008, le gain de la boucle CAG permettant de fixer un temps de réponse de la boucle de CAG. Un fort gain aura comme conséquence une boucle très réactive dans le cas d'une interférence continue, mais pouvant également réagir en cas d'une interférence pulsée longue (typiquement d'une durée supérieure à 1 ms) : la CAG risque alors de « pomper » à chaque impulsion.Avantageusement, le gain de la boucle CAG peut être ajusté en fonction du taux d'occupation temporelle d'impulsions dans la bande utile.

Avantageusement, le signal de commande CAG peut être filtré par un filtre de CAG 6009, par exemple formé par un intégrateur infini avec saturation permettant de diminuer la sensibilité de la commande à la présence d'impulsions.

Le principe de fonctionnement de l'architecture présentée dans la figure 6 peut ainsi être résumé de la manière suivante : pour un échantillon restitué par le CAN 15, une estimation de son amplitude ou de sa puissance est réalisée par le module d'estimation d'amplitude ou de puissance 6001. La valeur restituée par le module d'estimation d'amplitude ou de puissance 6001 est alors comparée avec la valeur de consigne CCAG 6005. La comparaison consiste par exemple en une soustraction de la valeur de consigne CCAG 6005. Si le résultat ou écart est négatif, le module de fonction non-linéaire 6006 restitue en sa sortie une valeur pondérée à raison de X% ; si l'écart est positif, alors le module de fonction non-linéaire 6006 restitue en sa sortie la valeur pondérée à raison de (1-X)%, la valeur de X correspondant au réglage appliqué par la fonction non-linéaire mise en oeuvre dans le module de fonction non-linéaire 6006, ce réglage étant déterminé par module de décision CAG 6004, selon la valeur du taux d'occupation temporelle des impulsions dans la bande utile.

Avantageusement, la valeur de consigne CCAG 6005 peut être adaptée au scénario d'interférences, via une commande adéquate émise par le module de décision CAG 6004. L'adaptation peut être réalisée via la mise en oeuvre d'une table de vérité, ou bien de formules arithmétiques. Par exemple, la valeur de consigne CAG sera majorée typiquement de 20% dans les scénarii d'interférences quasi-nulles, et réciproquement minorée de 20% dans des scénarii d'interférences à taux très élevé.

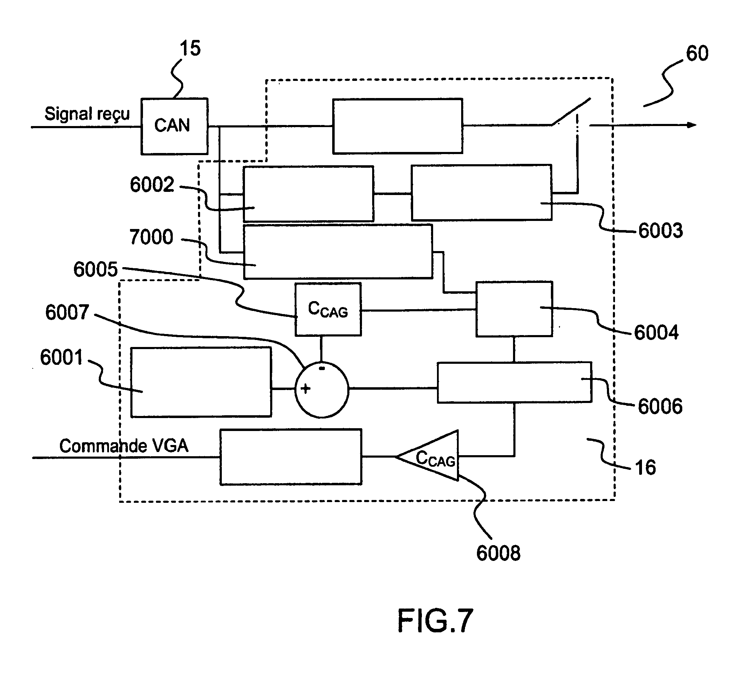

La figure 7 présente un diagramme fonctionnel illustrant un exemple d'architecture d'un récepteur GNSS comprenant une CAG selon un second exemple de réalisation de l'invention. L'architecture illustrée par la figure 7 est similaire à l'architecture décrite ci-avant en référence à la figure 6, et comprend notamment tous les éléments représentés dans la figure 6. Cependant, un module d'analyse des impulsions dans la bande utile 7000, comprenant également des moyens de filtrage, peut être inséré entre le CAN 15 et le module de décision CAG 6004. Le module d'analyse des impulsions dans la bande utile 7000 peut être dédié à l'analyse des impulsions dans la bande utile : il peut être basé sur une mesure d'amplitude ou de puissance qui est ensuite comparée à l'estimation d'amplitude ou de puissance du bruit thermique et des interférences continues potentielles, il peut être également basé sur un filtre adapté spectralement etc., et permettre ainsi d'obtenir un indicateur plus fiable du taux d'occupation des impulsions. Le module d'analyse des impulsions dans la bande utile 7000 peut comprendre des moyens de filtrage adaptés à la forme de chaque type d'impulsion. Les interférences DME (les plus critiques pour les nouveaux signaux dédiés aux applications aéronautiques) par exemple sont formées par deux impulsions de formes gaussiennes séparées de 12µs. Les impulsions radars sont habituellement formées par des séries d'impulsions carrées : par exemple, un train d'impulsions de quelques microsecondes émises par paquets de dix.

## Revendications

1. Dispositif de contrôle automatique de gain pour récepteur de positionnement par satellites comprenant au moins un module radiofréquence (14) restituant un signal radiofréquence filtré représentatif des signaux reçus par une antenne (11) et amplifié par un amplificateur à gain variable compris dans le module radiofréquence (14), un convertisseur analogique-numérique (15) restituant des échantillons numérisés du signal radiofréquence, et un module de traitement du signal (16) traitant le signal numérisé, le dispositif de contrôle automatique de gain étant mis en oeuvre dans le module de traitement du signal (16) et réalisant une boucle d'asservissement en restituant un signal de commande du gain de l'amplificateur à gain variable, et étant **caractérisé en ce qu'**il comprend des moyens d'estimation du taux d'occupation temporelle des impulsions dans la bande utile, des moyens d'estimation d'une grandeur caractéristique choisie dans le groupe comprenant l'amplitude et la puissance des signaux échantillonnés, le taux d'occupation temporelle des impulsions dans la bande utile déterminant les pondérations appliquées respectivement aux écarts négatifs et positifs résultant d'une comparaison entre la grandeur caractéristique des échantillons numérisés et une valeur de consigne CCAG (6005), par un module de fonction non-linéaire (6006), les signaux issus du module de fonction non-linéaire (6006) étant intégrés sur une période déterminée pour former ledit signal de commande du gain.

2. Dispositif de contrôle automatique de gain selon la revendication 1, **caractérisé en ce que** la détermination des pondérations est mise en oeuvre dans un module de décision CAG (6004) recevant en entrée une valeur de taux d'occupation d'impulsions dans la bande utile, et restituant en sortie une information de pondération audit module de fonction non-linéaire (6006).

3. Dispositif de contrôle automatique de gain selon l'une quelconque des revendications précédentes, **caractérisé en ce que** le module de fonction non-linéaire (6006) applique lesdites pondérations à partir d'une table de vérité de correspondance entre des taux d'occupation temporelle des impulsions dans la bande utile, et des réglages des taux respectifs de pondérations appliqués auxdits écarts négatifs et positifs.

4. Dispositif de contrôle automatique de gain selon la revendication 3, **caractérisé en ce que** lesdits réglages de pondération appliquent un taux de pondération de X% aux écarts négatifs et un taux de pondération de (1-X)% aux écarts positifs, X étant compris entre 0 et 100, et étant d'autant plus élevé que le taux d'occupation temporelle des impulsions dans la bande utile est élevé.

5. Dispositif de contrôle automatique de gain selon l'une quelconque des revendications précédentes, **caractérisé en ce qu'**il contient des moyens d'ajustement de la valeur de consigne CCAG (6005) configurés pour ajuster la valeur de la consigne CCAG (6005) en fonction du taux d'occupation temporelle des impulsions dans la bande utile.

6. Dispositif de contrôle automatique de gain selon l'une quelconque des revendications précédentes, **caractérisé en ce que** la détermination du taux d'occupation temporelle des impulsions dans la bande utile est mis en oeuvre dans un module de détection d'impulsions dans la bande utile (6002) compris dans ledit module de traitement du signal (16).

7. Dispositif de contrôle automatique de gain selon l'une quelconque des revendications 1 à 5, **caractérisé en ce que** la détermination du taux d'occupation temporelle des impulsions dans la bande utile est mis en oeuvre dans un module d'analyse des impulsions dans la bande utile (7000) comprenant au moins un filtre adapté spectralement à des types d'interférences pulsées prédéterminés.

8. Dispositif de contrôle automatique de gain selon l'une quelconque des revendications 2 à 7, **caractérisé en ce que** ladite boucle d'asservissement comprend un module de gain de boucle CAG (6008) dont le gain ajustable détermine le temps de réponse de la boucle d'asservissement.

9. Dispositif de contrôle automatique de gain selon la revendication 8, **caractérisé en ce que** le gain du module de gain de boucle est ajusté par un signal de commande restitué par le module de décision CAG (6004) en fonction du taux d'occupation temporelle des impulsions dans la bande utile.

## Patentansprüche

1. Automatische Verstärkungsregelvorrichtung für einen Satellitenpositionierungsempfänger, der Folgendes umfasst: wenigstens ein Funkfrequenzmodul (14), das ein gefiltertes Funkfrequenzsignal wiedergibt, das für Signale repräsentativ ist, die von einer Antenne (11) empfangen und von einem in dem Funkfrequenzmodul (14) enthaltenen Regelverstärker verstärkt werden, einen Analog-Digital-Wandler (15) zum Wiedergeben digitaler Samples des Funkfrequenzsignals, und ein Signalverarbeitungsmodul (16), das das digitale Signal verarbeitet, wobei die automatische Verstärkungsregelvorrichtung in dem Signalverarbeitungsmodul (16) implementiert wird und einen Regelkreis bildet, durch Wiedergeben eines Verstärkungsregelsignals des Regelverstärkers, und **dadurch gekennzeichnet, dass** sie Mittel zum Schätzen der zeitlichen Impulsbelegungsrate im nützlichen Band sowie Mittel zum Schätzen eines charakteristischen Wertes umfasst, der ausgewählt ist aus der Gruppe bestehend aus der Amplitude und der Leistung der abgetasteten Signale, wobei die zeitliche Impulsbelegungsrate im nützlichen Band die Gewichtungen bestimmt, die jeweils auf die negative und positive Differenz angewandt werden, die von einem Vergleich zwischen der charakteristischen Größe der digitalen Samples und einem Sollwert CCAG (6005) durch ein nichtlineares Funktionsmodul (6006) resultieren, wobei die von dem nichtlinearen Funktionsmodul (6006) kommenden Signale über eine bestimmte Periode integriert werden, um das Verstärkungsregelsignal zu bilden.

2. Automatische Verstärkungsregelvorrichtung nach Anspruch 1, **dadurch gekennzeichnet, dass** die Ermittlung der Gewichtungen in einem Entscheidungsmodul CAG (6004) erfolgt, das als Eingang einen Wert für die Impulsbelegungsrate im nützlichen Band empfängt und dem nichtlinearen Funktionsmodul (6006) Gewichtungsinformationen als Ausgang wiedergibt.

3. Automatische Regelverstärkungsvorrichtung nach einem der vorherigen Ansprüche, **dadurch gekennzeichnet, dass** das nichtlineare Funktionsmodul (6006) die Gewichtungen auf der Basis einer Wahrheitstabelle von Korrespondenzen zwischen den zeitlichen Impulsbelegungsraten im nützlichen Band und Justierungen der jeweiligen Gewichtungen anwendet, die auf die negative und positive Differenz angewendet werden.

4. Automatische Verstärkungsregelvorrichtung nach Anspruch 3, **dadurch gekennzeichnet, dass** die Gewichtungsjustierungen eine Gewichtungsrate von X % auf die negativen Differenzen und eine Gewichtungsrate von (1-X) % auf die positiven Differenzen anwenden, wobei X zwischen 0 und 100 liegt und umso höher ist, je höher die zeitliche Impulsbelegungsrate im nützlichen Band ist.

5. Automatische Verstärkungsregelvorrichtung nach einem der vorherigen Ansprüche, **dadurch gekennzeichnet, dass** sie Mittel zum Justieren des Sollwertes (6005) enthält, die zum Justieren des Sollwertes (6005) in Abhängigkeit von der zeitlichen Impulsbelegungsrate im nützlichen Band konfiguriert sind.

6. Automatische Verstärkungsregelvorrichtung nach einem der vorherigen Ansprüche, **dadurch gekennzeichnet, dass** das Ermitteln der zeitlichen Impulsbelegungsrate im nützlichen Band in einem Impulserkennungsmodul (6002) im nützlichen Band implementiert wird, das im Signalverarbeitungsmodul (16) enthalten ist.

7. Automatische Verstärkungsregelvorrichtung nach einem der Ansprüche 1 bis 5, **dadurch gekennzeichnet, dass** das Ermitteln der zeitlichen Impulsbelegungsrate im nützlichen Band in einem Modul (7000) zum Analysieren von Impulsen im nützlichen Band erfolgt, das wenigstens ein Filter umfasst, das spektral an bestimmte Typen von pulsierten Interferenzen angepasst ist.

8. Automatische Verstärkungsregelvorrichtung nach einem der Ansprüche 2 bis 7, **dadurch gekennzeichnet, dass** der Regelkreis ein Kreisverstärkungsmodul CAG (6008) umfasst, dessen justierbare Verstärkung die Ansprechzeit des Regelkreises bestimmt.

9. Automatische Verstärkungsregelvorrichtung nach Anspruch 8, **dadurch gekennzeichnet, dass** die Verstärkung des Kreisverstärkungsmoduls durch ein Steuersignal justiert wird, das vom Entscheidungsmodul CAG (6004) in Abhängigkeit von der zeitlichen Impulsbelegungsrate im nützlichen Band wiedergegeben wird.

## Claims

1. An automatic gain control device for a satellite positioning receiver, comprising at least one radio frequency module (14) reproducing a filtered radiofrequency signal that represents signals that are received by an antenna (11) and are amplified by a variable gain amplifier that is included in said radio frequency module (14), an analogue-digital converter (15) reproducing digital samples of the radiofrequency signal, and a signal processing module (16) processing the digitised signal, said automatic gain control device being implemented in said signal processing module (16) and realising a servo-control loop by reproducing a control signal of the gain of said variable gain amplifier, and **characterised in that** it comprises means for estimating the temporal occupancy rate of the pulses in the useful band, means for estimating a characteristic value that is selected from the group that comprises the amplitude and the power of the sampled signals, the temporal occupancy rate of the pulses in the useful band determining the weightings that are respectively applied to the negative and positive differences that result from a comparison between the characteristic magnitude of the digitised samples and a set-point value CCAG (6005) by a non-linear function module (6006), the signals coming from said non-linear function module (6006) being integrated over a determined period so as to form said gain control signal.

2. The automatic gain control device according to claim 1, **characterised in that** the determination of the weightings is implemented in a decision-making module CAG (6004) that receives as input a value of the occupancy rate of pulses in the useful band and reproduces as output weighting information to said non-linear function module (6006).

3. The automatic gain control device according to any one of the preceding claims, **characterised in that** said non-linear function module (6006) applies said weightings on the basis of a truth table of correspondence between the temporal occupancy rates of the pulses in the useful band and adjustments to the respective rates of weightings that are applied to said negative and positive differences.

4. The automatic gain control device according to claim 3, **characterised in that** said weighting adjustments apply a weighting rate of X% to the negative differences and a weighting rate of (1-X)% to the positive differences, with X being between 0 and 100 and being the higher the greater the temporal occupancy rate of the pulses in the useful band.

5. The automatic gain control device according to any one of the preceding claims, **characterised in that** it contains means for adjusting said set-point value (6005), which are configured to adjust said set-point value (6005) as a function of the temporal occupancy rate of the pulses in the useful band.

6. The automatic gain control device according to any one of the preceding claims, **characterised in that** the determination of the temporal occupancy rate of the pulses in the useful band is implemented in a pulse detection module (6002) in the useful band that is included in said signal processing module (16).

7. The automatic gain control device according to any one of claims 1 to 5, **characterised in that** the determination of the temporal occupancy rate of the pulses in the useful band is implemented in a module (7000) for analysing pulses in the useful band, which comprises at least one filter that is spectrally adapted to predetermined types of pulsed interference.

8. The automatic gain control device according to any one of claims 2 to 7, **characterised in that** said servo-control loop comprises a loop-gain module CAG (6008), the adjustable gain of which determines the response time of said servo-control loop.

9. The automatic gain control device according to claim 8, **characterised in that** the gain of said loop-gain module is adjusted by a control signal that is reproduced by said decision-making module CAG (6004) as a function of the temporal occupancy rate of the pulses in the useful band.
